# EUROPEAN PATENT SPECIFICATION

(11) **EP 1 126 753 B1**
(45) Date of publication and mention of the grant of the patent: **04.05.2005**
(21) Application number: 00126822.6
(22) Date of filing: 07.12.2000
(51) Int. Cl.: H05K 5/02, H05K 7/14

(54) **Plug-in card for electronic appliances**
Steckbare Karte für elektronische Geräte
Carte enfichable pour appareils électroniques

(30) Priority: 16.02.2000 DE 10006848
(43) Date of publication of application: 22.08.2001
(73) Proprietor: ITT MANUFACTURING ENTERPRISES, INC., Wilmington, Delaware 19801 (US)
(72) Inventor: Hanke, Brigitte, 73630 Remshalden (DE); Geiselmann, Gerhard, 73269 Hochdorf (DE)
(74) Representative: Dreiss, Fuhlendorf, Steimle & Becker

(56) References cited:
- EP-A- 0 865 233
- US-A- 5 768 110
- US-A- 6 018 461

## Description

The present invention relates to a plug-in card for electronic appliances according to the preamble of Claim 1.

DE-A-44 06 644 discloses metallic casing elements that are of half-shell design and that have at their one end bent-over lugs that are inserted into slots, accessible from the surface, of a plug connector, whereafter the two casing elements can be swivelled towards each other and can be latched together or laser-welded.

Such a preassembleed lug/groove joint between casing element and plug connector is relatively loose for the purpose of latching or laser-welding the two casing elements together, and this makes manipulation difficult during the further assembling.

In the case of a plug-in card disclosed in DE-A-197 10 515 of the type mentioned at the outset, the one metallic part of the upper casing element is provided with two outer and a centre lug crimped with respect to the plane of said part, and the other plastic part of said upper casing element is provided with two outer slots and a central groove. The one part of said upper casing element is set up perpendicularly with respect to the other part, the outer lugs being introduced into the outer slots. The central lug is brought through the groove underneath the rim of the other part of the upper casing element by central pressure on the one part swivelled simultaneously towards the other. For this type of preassembling of the two parts of the upper casing element, the mutually adjacent rims have to be provided with mutually fitting arched sections and, in addition, the two operations (exertion of pressure and swivelling) have to be performed simultaneously.

The object of the present invention is therefore to provide a plug-in card for electronic appliances of the type mentioned at the outset, in which the preassembling of individual casing elements or casing parts can be manipulated together more simply.

To achieve this object, the features specified in Claim 1 are provided in a plug-in card for electronic appliances of the type mentioned at the outset.

The measures according to the invention achieve a simplification of the production and the mutual assembling of the individual casing parts or casing elements. In addition, in this way, not only can the two parts of the upper casing element be latched in a more rapid and simpler way, but also the lower casing element can be latched in a more rapid and simpler way to the upper casing element. Those parts or elements of the casing preassembled in this way are consequently not loosely held together, with the result that they cannot unintentionally come apart again. Furthermore, the one part is simultaneously aligned with the other part of the upper casing element or the two casing elements are aligned with each other.

Advantageous refinements for joining the two parts of the one upper casing part and/or for joining lower and upper casing parts emerge from the features of one or more of the subclaims.

Further details of the invention are to be found in the description below, in which the invention is described and explained in greater detail by reference to exemplary embodiments shown in the drawing. In the drawing:
Figure 1 shows, in a perspective diagrammatic view, a plug-in card for electronic appliances in the assembled state, in accordance with an exemplary embodiment of the present invention,
Figures 2A and 2B show, in a perspective plan view or view, from below the one part of the upper casing element of the plug-in card according to Figure 1,
Figures 3A and 3B show, in a perspective, partly broken-away view, the joining region of the two parts of the upper casing element viewed from above or from below, respectively, and after or before assembly, respectively,
Figures 4A and 4B show, in a perspective, partly broken-away view, the joining region of the one part of the upper casing element to the lower casing element viewed from above or from below, respectively and after or before assembly, respectively and
Figures 5A and 5B show, in a perspective diagrammatic view and in a broken-away longitudinal section, respectively, a plug-in card for electronic appliances in the joining region of the casing parts or casing elements in accordance with another exemplary embodiment of the present invention.

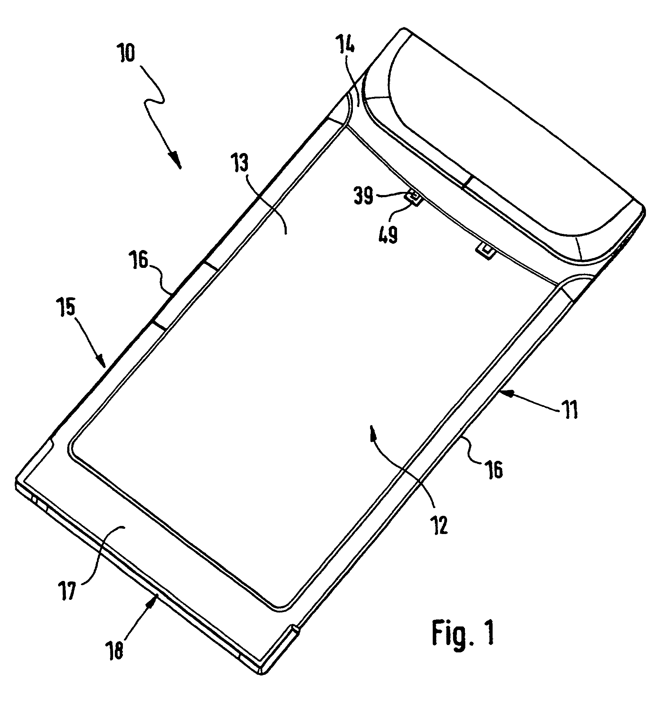

The plug-in card 10 shown in the assembled state in Figure 1 for electronic appliances in accordance with an exemplary embodiment of the present invention has a casing 15 composed of a lower, integral casing element 11 and an upper casing element 12 comprising two parts 13 and 14. The lower casing element 11 and the one front part 13 of the upper casing element 12 of the plug-in card 10, which has an elongated rectangular, shallow shape, comprise thin, shaped metal sheets and engage over each other or in each other by means of their long-side rims 16. A plug connector 18 shown only diagrammatically is held in a fixed position at the front transverse side 17. Disposed between the two casing elements 11 and 12 is a printed circuit board that is not shown here and that extends substantially over the entire base area of the lower casing element 11 or of the plug-in card 10, respectively.

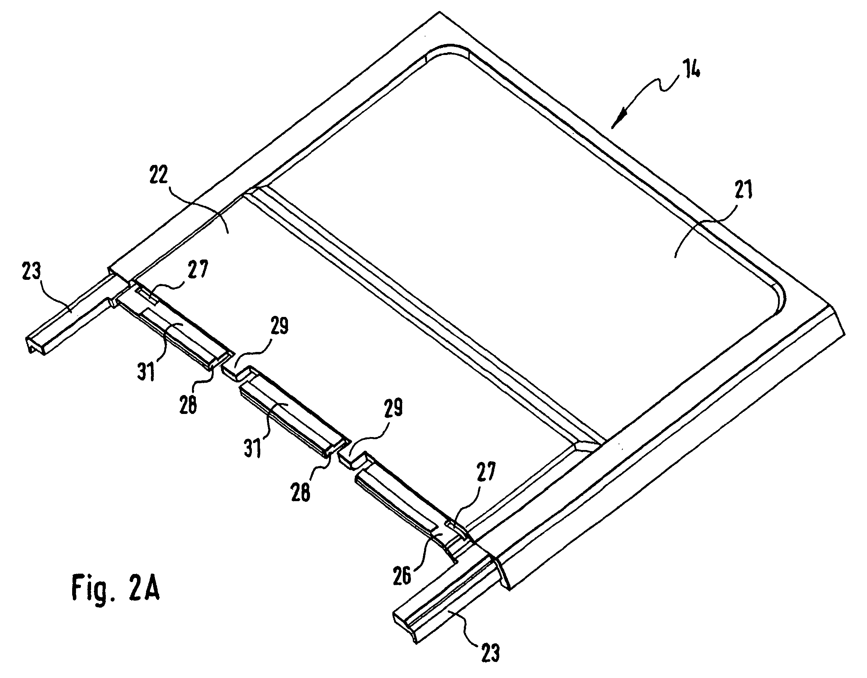

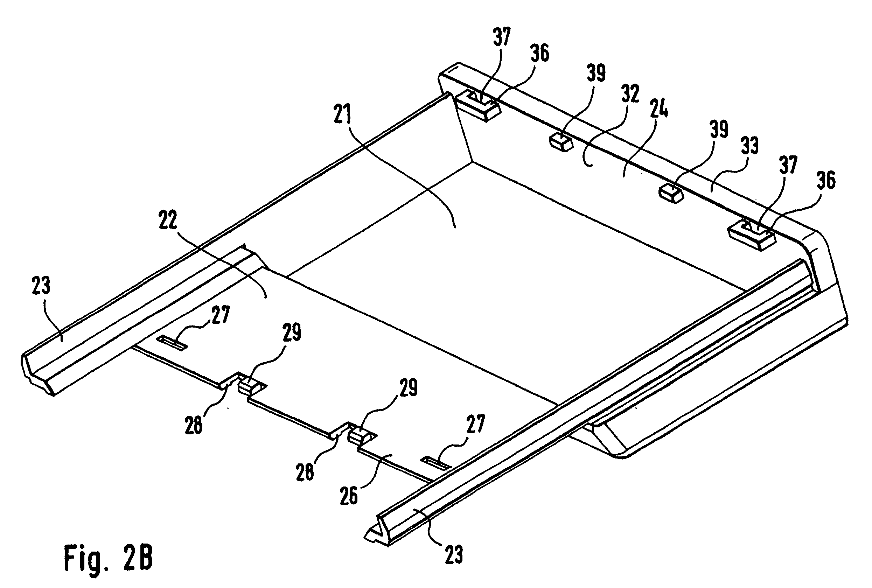

In accordance with Figures 2A and 2B, the other rear casing part 14, which is composed of plastic, of the one upper casing element 12 is substantially integral and rectangular, a shallower region 22 that is provided with two outer longitudinally directed bars 23 L-shaped in section between which, in a manner not shown, the printed circuit board, which extends substantially to the rear end face 24 of the plastic casing part 14, is received in a guided manner, joins a hood-like region 21. The raised hood-like region 21 serves, for example, to receive larger electronic components provided on the printed circuit board.

At its front rim 26 remote from the rear end face 24, the rear casing part 14 has, near each of the bars 23, a longitudinally rectangular slot 27 that extends parallel to the rim 26 and is at a certain distance from the edge of the rim 26. Provided between the two slots 27 that pass through the rim 26 from the outside to the inside are open grooves 28 that proceed from the edge of the rim 26 and that are disposed at a distance from one another. The spacings between slot 27 and groove 28 or the two grooves 28, respectively, are each approximately equal in the exemplary embodiment shown. The base of the grooves 28 is in line with the rear boundary of the slots 27. Situated in each groove 28 is a finger 29 that is formed onto the groove base and that is narrower than the groove 28 is wide and is shorter than the groove 28 is deep. Between the slots 27 and the grooves 28, the surface of the rim 26 is provided with a recess 31 that is set back with respect to the edge and that is narrower than the rim 26 is wide.

The other rear plastic casing part 14 of the one upper casing element 12 has, in addition, outer protrusions 36 that project from the internal surface 32 of the rear wall 24 and adjoin the lower edge 33 and that are each provided with through slots 37 extending over their thickness. Two fingers 39 are formed on centrally between the two outer protrusions 36. The spacings between the slots 37 and the fingers 39 are approximately equal.

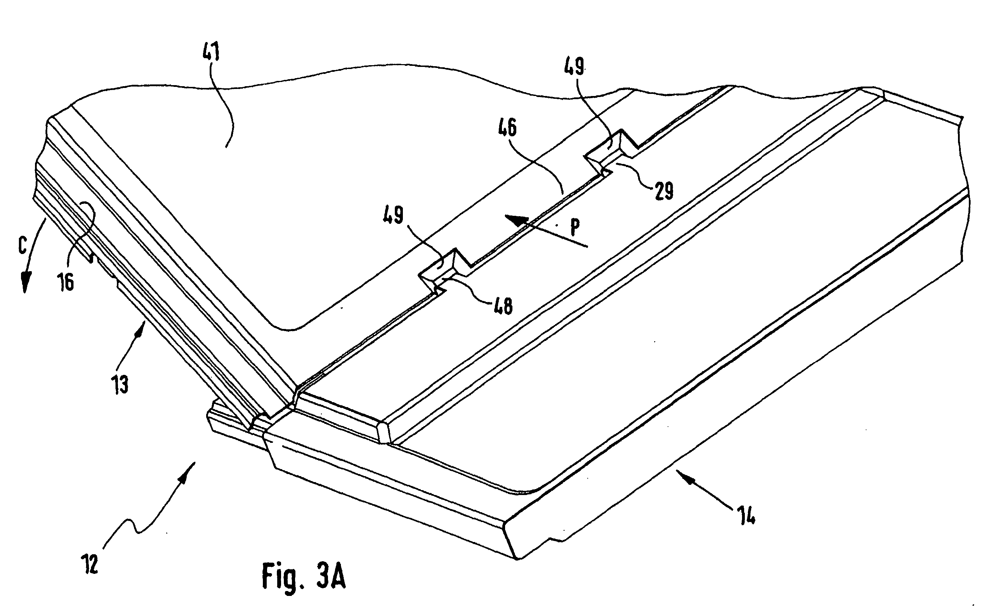

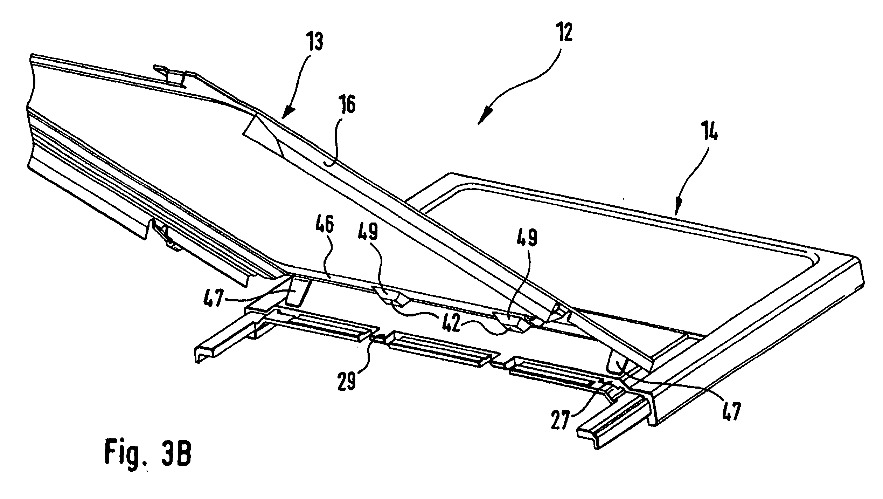

In accordance with Figures 3A and 3B, the one front metallic casing part 13 has, for the purpose of joining to the other rear plastic casing part 14, outer lugs 47 that are bent over at right angles with respect to the surface of the casing part 13 at its respective rim 46. Indentations 49 that are disposed at a distance are formed into the upper side 41 of the metal sheet of the front casing part 13 between the two outer lugs 47 in such a way that the base 48 of the indentation 49 is situated more deeply with respect to the surface of the metal casing part 13 by the thickness of the finger 29 on the rear plastic casing part 14 and extends up to the free edge or end face. The spacing of the outer lugs 47 and the central indentations 49 is approximately equal and such that the lugs 47 and the indentations 49 of the front casing part 13 fit the slots 27 or the fingers 29, respectively, of the rear casing part 14.

Figures 3A and 3B reveal that, for the purpose of preassembling the front casing part 13 on the rear casing part 14, the front casing part 13 is applied obliquely at an acute angle at the rear casing part 14 and the outer lugs 47 are fed into the slots 27 (Figure 3B). In this connection, to feed in at an inclined angle in this way, the slots 27 are somewhat wider than the lugs 47 are thick. The length of the slots 27 is substantially equal to approximately the width of the lugs 47. Once the lugs 47 have been fed into the slots 27, the lower side 42 of the indentations 49 are situated on the upper side of the fingers 29. As a result of pressing on the front metal casing part 13 in the region of the indentations 49, preferably between the two indentations 49, in the direction of the arrow P (Figure 3A), the metal sheet of the front casing part 13 can be deformed elastically in this region in such a way that the free edges of the indentations 49 slide over the surface of the fingers 29 and their free ends, with the result that the base 48 of the indentations 49 reaches the lower side of the fingers 29 (Figure 3A). If the front casing part 13 is then swivelled in the direction of the arrow C towards the printed circuit board, which is not shown, or towards the lower casing element 11, the fingers 29 locate themselves complete in the indentations 49 and the edge, slightly bent inwards, of the rim 46 of the front metal casing part 13 locates itself in the recess 31 of the rim 26 of the rear plastic casing part 14.

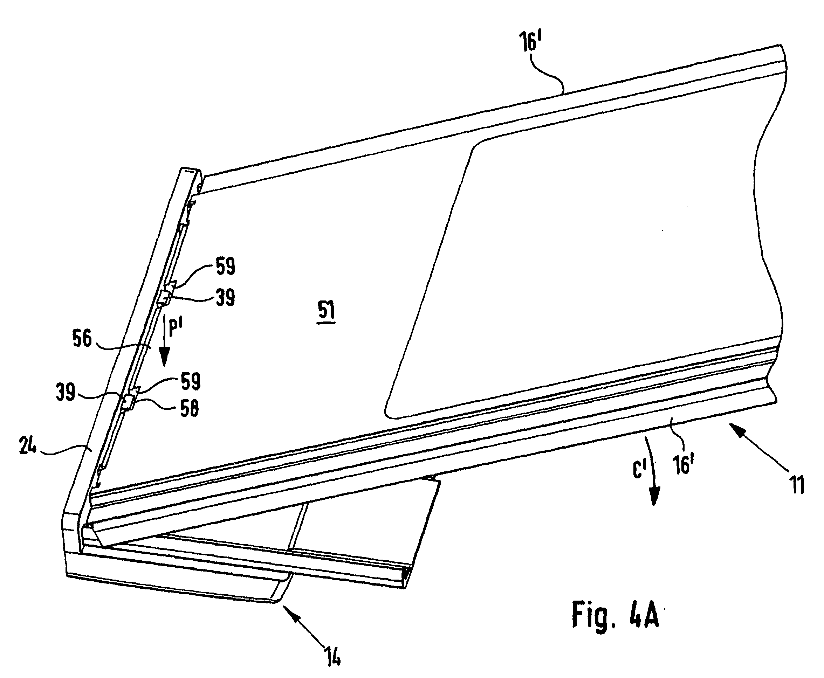

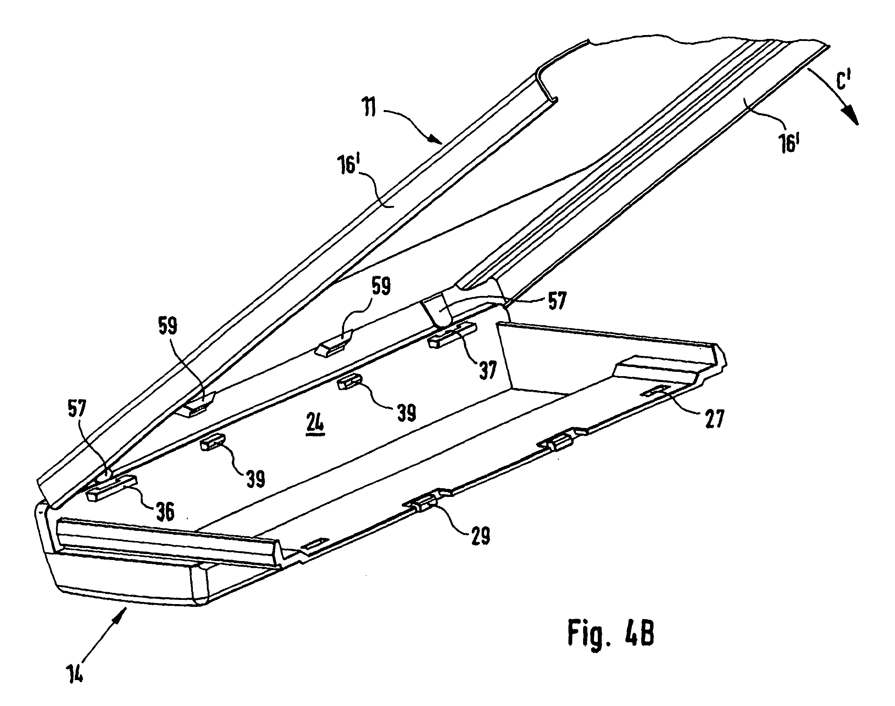

Figures 4A and 4B show a corresponding preassembling of the other lower casing element 11 on the rear plastic casing part 14 of the upper casing element 12. At the respective rim 56, the lower, metallic casing element 11 has outer lugs 57 bent over at right angles and central indentations 59 whose base 58 is displaced by the thickness of the fingers 39 with respect to the upper side 51 of the lower casing element 11. As can be seen from Figures 4A and 4B, the preassembling takes place in a corresponding manner to that described by reference to Figures 3A and 3B in the case of the mutual preassembling of the two casing parts 13 and 14 of the upper casing element 12. The lugs 57 of the lower casing element 11 engage in the slots 37 of the rear casing part 14 and the indentations 59 are brought behind the fingers 39 on the rear casing part 14 by appropriate central pressure (arrow P') on the rim of the lower casing element 11 (Figure 4A). The lower casing element 11 is then swivelled towards the printed circuit board, which is not shown (arrow C').

When the lower metallic casing element 11 and the front metallic casing part 13 are swivelled towards each other, their longitudinal side rims 16 and 16' are latched together in a manner not shown in further detail so as to overlap.

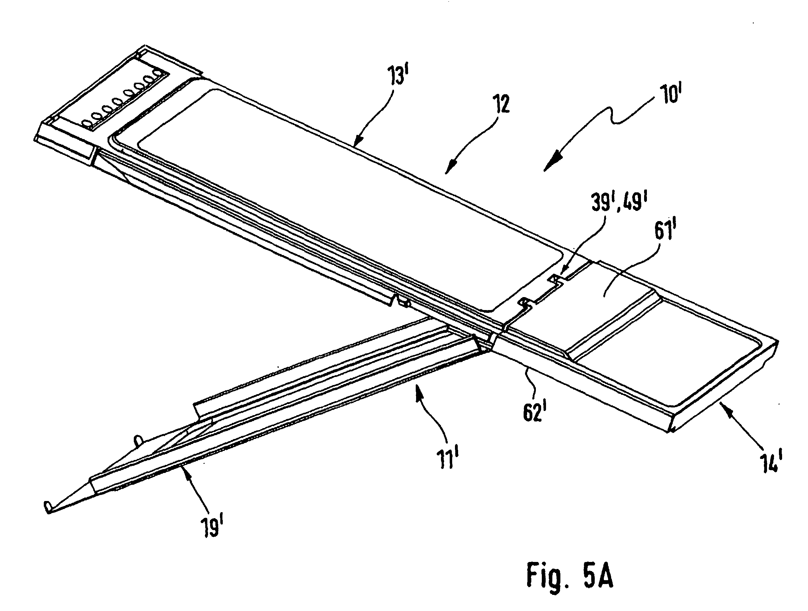

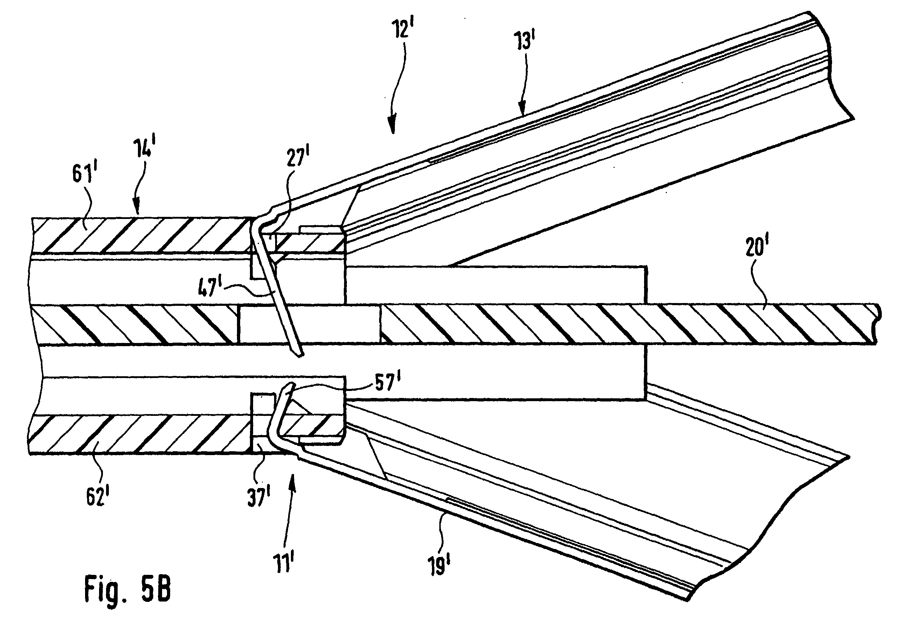

In the further exemplary embodiment of the present invention shown in Figures 5A and 5B, in the case of the plug-in card 10', not only is the upper casing element 12' divided, but also the lower casing element 11', with the result that both a front metallic casing part 13' of the upper casing element 12' and a front metallic casing part 19' of the lower casing element 11' are present. Common to these two metallic casing parts 13' and 19' is a rear plastic casing part 14'. Said rear plastic casing part 14', which is, for example, integral, is designed both at its upper wall 61' and at its lower wall 62' corresponding to the rear plastic casing part 14 shown in Figure 1 for joining both to the metallic casing part 13' of the upper casing element 12' and to the metallic casing part 19' of the lower casing element 11'. In a corresponding manner, both front metallic casing parts 13' and 19' are consequently designed for preassembling as described above.

The only difference in Figure 5B is that the outer lugs 47' of the front metallic casing part 13' of the upper casing element 12' are longer than corresponds to the thickness of the upper wall 61' of the rear plastic casing part 14'. The outer lugs 47' are so long that they engage in a recess of the printed circuit board 20', shown diagrammatically in Figure 5B of the plug-in card 10'.

In accordance with variants not shown, either only one indentation or, for example, three indentations is/are provided centrally on the metallic casing part.

## Claims

1. Plug-in card (10) for electronic appliances, having an approximately longitudinally rectangular, shallow shape, having a casing (15) comprising an upper and a lower casing element (12, 11) of substantially half-shell-type design, wherein the one casing element (12, 11) is formed by two parts (13, 14) at the end face that are mutually pluggable, having a printed circuit board received in the casing (15) and having a plug connector (18) held at one transverse end face (17), **characterized in that** the other part (14) of the one casing element (12) has, along its straight rim (26, 24) adjacent to the one part (13) of the one casing element (12) and/or the other casing element (11), in an alternating manner at least one slot (27, 37) open to the upper side and lower side and at least one finger (29, 39) projecting from the rim (26, 24), and the one part (13) of the one casing element (12) and/or the other casing element (11) has at least one lug (47, 57) projecting at an angle from its flat end face and at least one indentation (49, 59) extending up to the flat end face and introduced into the surface for the respective engagement in the slot (27, 37) or under the finger (29, 39) of the adjacent rim of the other part (14) of the one casing element.

2. Plug-in card according to Claim 1, **characterized in that** the rim (26) of the other part (14) of the one casing element (12) is provided with two outer slots (27, 37) and two central fingers (29, 39).

3. Plug-in card according to Claim 2, **characterized in that** the respective spacings between adjacent slots (27, 37) and fingers (29, 39) are equal.

4. Plug-in card according to at least one of Claims 1 to 3, **characterized in that** the dimension of the depth of the indentation (49, 59) of the one part (13) of the one casing element (12) or of the other casing element (11), respectively, is substantially equal to the thickness of the finger (29, 39) of the other part (14) of the one casing element (12).

5. Plug-in card according to at least one of the preceding claims, **characterized in that** the finger (29) is disposed centrally inside an open groove (28) on that rim of the other part (14) of the one casing element (12) that is adjacent to the one part (13) of the one casing element (12).

6. Plug-in card according to Claim 5, **characterized in that** the finger (29) is not as long as the groove (28) is deep.

7. Plug-in card according to at least one of the preceding claims, **characterized in that** the finger (39) on that rim of the other part (14) of the one casing element (12) adjacent to the other casing element (11) projects perpendicularly inwards from a wall (24) terminating the casing (15) at its narrow end face.

8. Plug-in card according to Claim 7, **characterized in that** protrusions (36) provided with the slots (37) are provided parallel to the finger (39) for the other casing element (11).

9. Plug-in card according to at least one of the preceding claims, **characterized in that**, with the outer lugs (47, 57) of the one part (13) of the one casing element (12) or of the other casing element (11), respectively, plugged into the slots (27, 37) of the other part (14) of the one casing element (12) and with it positioned at an acute angle with respect to the other part (14) of the one casing element (12), its indentation (49, 59) or indentations can be latched under the finger or the fingers (29, 39) of the other part (14) of the one casing element (12) by pressure on the transverse centre of the surface of the one part (13) of the one casing element (12) or of the other casing element (11), respectively.

10. Plug-in card according to Claim 9, **characterized in that** the slot (27, 37) is somewhat wider than the lug (47, 57) is thick.

11. Plug-in card according to at least one of the preceding claims, **characterized in that** the lug (47, 57) is longer than the other part (14) of the one casing element (12) is thick.

12. Plug-in card according to at least one of the preceding claims, **characterized in that** the one, upper casing element (12) is in two parts and the other, lower casing element (11) is integral or in two parts.

13. Plug-in card according to at least one of the preceding claims, **characterized in that** the other part (14) of the one, upper casing element (12) is of plastic and the one part (13) of the one, upper casing element (12) and also the other, lower casing element (11) are of thin metal sheet.

14. Plug-in card according to Claims 1 and 13, **characterized in that** the metallic part (13) of the one upper casing element (12) and the other lower metallic casing element (11) or its metallic part (19') can be latched together on the longitudinal rim side.

## Patentansprüche

1. Steckkarte (10) für elektronische Geräte, in etwa länglich-rechteckförmiger, flacher Form, mit einem ein oberes und ein unteres im Wesentlichen halbschalenartig ausgebildetes Gehäuseelement (12, 11) aufweisenden Gehäuse (15), wobei das eine Gehäuseelement (12, 11) durch zwei endseitig steckbar miteinander verbindbare Teile (13, 14) gebildet ist, mit einer im Gehäuse (15) aufgenommenen Leiterplatte und mit einem an einem Querende (17) gehaltenen Steckverbinder (18), **dadurch gekennzeichnet, dass** das andere Teil (14) des einen Gehäuseelementes (12) längs seines dem einen Teil (13) des einen Gehäuseelementes (12) und/oder dem anderen Gehäuseelement (11) zugewandten geraden Randes (26, 24) abwechselnd mindestens einen zur Ober- und Unterseite hin offenen Schlitz (27, 37) und mindestens einen vom Rand (26, 24) abstehenden Finger (29, 39) und das eine Teil (13) des einen Gehäuseelementes (12) und/oder das andere Gehäuseelement (11) von seiner ebenen Stirn mindestens einen abgewinkelt abstehenden Lappen (47, 57) und mindestens einen zur ebenen Stirn reichenden, in die Oberfläche eingebrachten Eindruck (49, 59) zum jeweiligen Eingriff in den Schlitz (27, 37) bzw. unter den Finger (29, 39) des zugewandten Randes des anderen Teils (14) des einen Gehäuseelementes aufweist.

2. Steckkarte nach Anspruch 1, **dadurch gekennzeichnet, dass** der Rand (26) des anderen Teils (14) des einen Gehäuseelements (12) mit zwei äußeren Schlitzen (27, 37) und zwei mittigen Fingern (29, 39) versehen ist.

3. Steckkarte nach Anspruch 2, **dadurch gekennzeichnet, dass** die jeweiligen Abstände zwischen benachbarten Schlitzen (27, 37) und Fingern (29, 39) gleich sind.

4. Steckkarte nach mindestens einem der Ansprüche 1 bis 3, **dadurch gekennzeichnet, dass** das Maß der Tiefe des Eindruckes (49, 59) des einen Teils (13) des einen Gehäuseelementes (12) bzw. des anderen Gehäuseelementes (11) im Wesentlichen gleich der Dicke des Fingers (29, 39) des anderen Teils (14) des einen Gehäuseelementes (12) ist.

5. Steckkarte nach mindestens einem der vorhergehenden Ansprüche, **dadurch gekennzeichnet, dass** der Finger (29) am dem einen Teil (13) des einen Gehäuseelementes (12) zugewandten Rand des anderen Teils (14) des einen Gehäuseelementes (12) mittig innerhalb einer offenen Nut (28) angeordnet ist.

6. Steckkarte nach Anspruch 5, **dadurch gekennzeichnet, dass** der Finger (29) weniger lang als die Nut (28) tief ist.

7. Steckkarte nach mindestens einem der vorhergehenden Ansprüche, **dadurch gekennzeichnet, dass** der Finger (39) am dem anderen Gehäuseelement (11) zugewandten Rand des anderen Teils (14) des einen Gehäuseelementes (12) senkrecht nach innen von einem das Gehäuse (15) an einer schmalen Stirn abschließenden Wand (24) absteht.

8. Steckkarte nach Anspruch 7, **dadurch gekennzeichnet, dass** parallel zum Finger (39) für das andere Gehäuseelement (11) mit den Schlitzen (37) versehene Vorsprünge (36) vorgesehen sind.

9. Steckkarte nach mindestens einem der vorhergehenden Ansprüche, **dadurch gekennzeichnet, dass** bei in die Schlitze (27, 37) des anderen Teils (14) des einen , Gehäuseelementes (12) eingesteckte äußere Lappen (47, 57) des einen Teils (13) des einen Gehäuseelementes (12) bzw. des anderen Gehäuseelementes (11) und dessen gegenüber dem anderen Teil (14) des einen Gehäuseelementes (12) spitzwinklig schräggestellter Lage durch Druck auf die Quermitte der Oberfläche des einen Teils (13) des einen Gehäuseelementes (12) bzw. des anderen Gehäuseelementes (11) dessen Eindruck (49, 59) oder Eindrücke unter den oder die Finger (29, 39) des anderen Teils (14) des einen Gehäuseelementes (12) rastbar sind.

10. Steckkarte nach Anspruch 9, **dadurch gekennzeichnet, dass** der Schlitz (27, 37) etwas breiter als der Lappen (47, 57) dick ist.

11. Steckkarte nach mindestens einem der vorhergehenden Ansprüche, **dadurch gekennzeichnet, dass** der Lappen (47, 57) länger ist als der andere Teil (14) des einen Gehäuseelementes (12) dick ist.

12. Steckkarte nach mindestens einem der vorhergehenden Ansprüche, **dadurch gekennzeichnet, dass** das eine obere Gehäuseelement (12) zweiteilig und das andere untere Gehäuseelement (11) ein- oder zweiteilig ist.

13. Steckkarte nach mindestens einem der vorhergehenden Ansprüche, **dadurch gekennzeichnet, dass** das andere Teil (14) des einen oberen Gehäuseelements (12) aus Kunststoff und das eine Teil (13) des einen oberen Gehäuseelements (12) sowie das andere untere Gehäuseelement (11) aus dünnem Metallblech ist.

14. Steckkarte nach den Ansprüchen 1 und 13, **dadurch gekennzeichnet, dass** der metallische Teil (13) des einen oberen Gehäuseelements (12) und das andere untere metallische Gehäuseelement (11) bzw. dessen metallischer Teil (19') längsrandseitig miteinander verrastbar sind.

## Revendications

1. Carte enfichable (10) pour appareils électroniques, ayant une forme approximative longitudinalement rectangulaire, de faible épaisseur, ayant un boîtier (15) comprenant un élément de boîtier supérieur et un élément de boîtier inférieur (12, 11) avec une conception sensiblement en forme de demi-coque, dans laquelle l'un des éléments de boîtier (12, 11) est formé en deux parties (13, 14) au niveau de la face terminale, qui sont susceptibles d'être mutuellement enfichées, qui comportent une carte à circuits imprimés reçue dans le boîtier (15), et qui comportent un connecteur enfichable (18) tenu au niveau d'une face terminale transversale (17), **caractérisée en ce que** l'autre partie (14) dudit élément de boîtier (12) possède, le long de son rebord rectiligne (26, 24) adjacent à ladite première partie (13) dudit élément de boîtier (12) et/ou à l'autre élément de boîtier (11), disposés de manière alternante, au moins une fente (27, 37) ouverte vers le côté supérieur et vers le côté inférieur, et au moins un doigt (29, 39) qui se projette depuis le rebord (26, 24), et ladite première partie (13) dudit élément de boîtier (12) et/ou l'autre élément de boîtier (11) comporte au moins une patte (47, 57) qui se projette sous un angle depuis sa face terminale plane, et au moins un relief (49, 59) qui s'étend jusqu'à la face terminale plane et qui est ménagé dans la surface pour l'engagement respectif dans la fente (27, 37) ou sous le doigt (29, 39) du rebord adjacent de l'autre partie (14) de l'élément de boîtier.

2. Carte enfichable selon la revendication 1, **caractérisée en ce que** le rebord (26) de l'autre partie (14) dudit élément de boîtier (12) est pourvu de deux fentes extérieures (27, 37) et de deux doigts centraux (29, 39).

3. Carte enfichable selon la revendication 2, **caractérisée en ce que** les espacements respectifs entre des fentes (27, 37) et des doigts (29, 39) adjacent(e)s sont égaux.

4. Carte enfichable selon l'une au moins des revendications 1 à 3, **caractérisée en ce que** la dimension ou la profondeur du relief (49, 59) d'une partie (13) dudit élément de boîtier (12), ou de l'autre élément de boîtier (11), respectivement, est sensiblement égale à l'épaisseur du doigt (29, 39) de l'autre partie (14) dudit élément de boîtier (12).

5. Carte enfichable selon l'une au moins des revendications précédentes, **caractérisée en ce que** le doigt (29) est disposé au centre à l'intérieur d'une gorge ouverte (28) sur ce rebord de l'autre partie (14) dudit élément de boîtier (12) qui est adjacent à ladite partie (13) dudit élément de boîtier (12).

6. Carte enfichable selon la revendication 5, **caractérisée en ce que** le doigt (29) a une longueur inférieure à la profondeur de la gorge (28).

7. Carte enfichable selon l'une au moins des revendications précédentes, **caractérisée en ce que** le doigt (39) sur ce rebord de l'autre partie (14) dudit élément de boîtier (12) adjacent à l'autre élément de boîtier (11) se projette perpendiculairement vers l'intérieur depuis une paroi (24) qui termine de boîtier (15) au niveau de sa face terminale étroite.

8. Carte enfichable selon la revendication 7, **caractérisée en ce que** des projections (36) pourvues des fentes (37) sont prévues parallèlement au doigt (39) pour l'autre élément de boîtier (11).

9. Carte enfichable selon l'une au moins des revendications précédentes, **caractérisée en ce que**, quand les pattes extérieures (47, 57) d'une partie (13) dudit élément de boîtier (12) ou de l'autre élément de boîtier (11), respectivement, sont enfichées dans les fentes (27, 37) de l'autre partie (14) dudit élément de boîtier (12) et sont positionnées avec elles sous un angle aigu par rapport à l'autre partie (14) dudit élément de boîtier (12), son ou ses relief(s) (49, 59) peut/peuvent être verrouillé(s) sous le doigt ou les doigts (29, 39) de l'autre partie (14) dudit élément de boîtier (12) par pression sur le centre transversal de la surface de ladite partie (13) dudit élément de boîtier (12) ou de l'autre élément de boîtier (11), respectivement.

10. Carte enfichable selon la revendication 9, **caractérisée en ce que** la fente (27, 37) a une largeur que quelque peu supérieure à l'épaisseur de la patte (47, 57).

11. Carte enfichable selon l'une au moins des revendications précédentes, **caractérisée en ce que** la patte (47, 57) a une longueur supérieure à l'épaisseur de l'autre partie (14) dudit élément de boîtier (12).

12. Carte enfichable selon l'une au moins des revendications précédentes, **caractérisée en ce que** ledit élément de boîtier supérieur (12) est en deux parties, et l'autre élément de boîtier inférieur (11) est intégral ou en deux parties.

13. Carte enfichable selon l'une au moins des revendications précédentes, **caractérisée en ce que** l'autre partie (14) dudit élément de boîtier supérieur (12) est en matière plastique, et la partie (13) de l'élément de casier supérieur (12) est en mince tôle métallique, de même que l'autre élément de boîtier inférieur (11).

14. Carte enfichable selon les revendications 1 est 13, **caractérisée en ce que** la partie métallique (13) de l'élément de boîtier supérieur (12) et l'autre élément de boîtier métallique inférieur (11), ou sa partie métallique (19'), peuvent être verrouillés ensemble sur le côté du rebord longitudinal.
